# EUROPEAN PATENT APPLICATION

(11) **EP 1 447 857 A1**
(43) Date of publication of application: **18.08.2004**
(21) Application number: 03425087.8
(22) Date of filing: 12.02.2003
(51) Int. Cl.: H01L 39/12

(54) **Sc1-xMgxB2 superconductors tuned at a shape resonance for Tc amplification**

(71) Applicant: Bianconi, Antonio, 00186 Roma (IT)
(72) Inventor: Agrestini, Stefano, Roma (IT); Bianconi, Antonio, Roma (IT)

(57) **Abstract**

Superconductors of chemical formula Sc₁₋ₓMgₓB₂ with x tuned in the range between 0.7 and 0.9 (0.7<x<0.9), being formed by a superlattice of superconducting boron (B) monolayers (1) intercalated by magnesium and scandium (Sc/Mg) monolayers (2) with period λₚ in c-axis direction (z), have been synthesized at high temperature between 1280°C and 950°C. The superconducting critical temperature is amplified from 4K to 20K for x varying from x=0.7 to x=0.9 by changing the charge transfer y=3-x, from the (Sc/Mg) layers to the boron layers in the range 2.3>y>2.1 to tune the Fermi level in order to satisfy the "shape resonance" condition at y∼2.13±0.03.

## Description

### Technical Field

The present invention relates to superconductors according to the first part of claims forming a superlattice made by first portions of a superconducting boron monolayers intercalated by second portions of scandium and magnesium monolayers that play the role of spacers and form a ternary intermetallic of chemical formula Sc₁₋ₓMgₓB₂ where x is the concentration of magnesium and 1-x the concentration of scandium in a particular range of x content in the range between 0.7 and 0.9 (0.7<x<0.9).

Moreover the invention relates to a particular method to realize superconductors where the critical temperature is controlled using the process described in the claim 2 of the patent, that will be cited below as SMHAL ("High T_{C} superconductors made by metal heterostuctures at the atomic limit" European Patent No. EP 0733271 published in the European Patent Bulletin 98/22, (1998); and Japanese patent No. JP 286 8621) and the US patent ("Process of Increasing the Critical Temperature T_{c} of a Bulk Superconductor by Making Metal Hetrostructures at the Atomic Limit" United State Patent No.:US6,265,019 B1, Jul. 24, 2001).

It is well known that a wide industrial application of superconductivity is limited by the fact that the superconducting metals available on the market exhibit low critical temperature T_{c} (the critical temperature (T_{c}) indicates the temperature for the onset of the superconductivity, i.e., for the zero resistivity and perfect diamagnetism) that imply high cost and difficulties in the operation therefore the research in this field is addressed to realize new superconducting materials that will show higher critical temperatures. The synthesis of new high temperature superconductors has been driven by empirical approaches therefore it is necessary to develop the synthesis of new superconductors by material design controlling the superconducting critical temperature.

### Background Art

The progress in search for new superconducting materials advanced by empirical approaches: the research has been focused first (1911-1940) on metals of simple atomic elements, second (1940-1987) on transition metal alloys; third (1987-1993) to perovskite ceramic materials however these materials are fragile and difficult to shape. These difficulties generate limits for the industrial applications for energy transport, magnetic levitation, superconducting electronic devices, and electrical contact in computers. A recent innovation in this field are the high-temperature superconductors formed by metal heterostructures at the atomic limit described in the recent patent (SMHAL) formed by superlattices made of of superconducting stripes, where the process of T_{c} amplification is described in the paper (Physica C, Vol. 296, Pag. 269 (1998) A. Bianconi, A. Valletta, A. Perali, and N. L. Saini, "Superconductivity of a striped phase at the atomic limit"), or made of superconducting layers like it has been shown to be feasible in the case of superlattices of boron layers intercalated by aluminum magnesium layers as reported in the papers (J. Phys.: Condens. Matter, Vol. 13 Page 7383-7390 (2001); A. Bianconi, D. Di Castro, S. Agrestini, G. Campi, N. L. Saini, A. Saccone, S. De Negri and M. Giovannini "A superconductor made by a metal heterostructure at the atomic limit tuned at the 'shape resonance'; and preprint in arXiv:cond-mat/0211389, 20 November 2002, A. Bussmann-Holder and A. Bianconi " The T_{c} amplification by quantum interference effects in diborides" ) that have been obtained by chemical synthesis of ternary intermetallic compounds Mg₁₋ₓAlₓB₂ with x in the range 0<x<0.5 prepared according with the paper (Zh. Prikl. Khim. (Leningrad) Vol. 44 page 958 (1971) N. V. Vekshina, L. Ya. Markovskii, Yu. D. Kondrashev, T. K. Voevodskyaya). It is well known that the simple binary intermetallic compound MgB₂ (or Mg²⁺B₂) known from decades (J. Am. Chem. Soc. Vol. 76 Page 1434 (1954) E. Jones and B. Marsh) with the simple AlB₂ structure (Naturwiss. Vol. 23 Page 851 (1935) W. Hoffmann and W. Janicke; Z. Physik. Chem. Vol. 31 B, Page 214 (1936)) only recently has been used as a superconductor with critical temperature of 39 degree's Kelvin (T_{c}=39K) (Nature Vol. 410 Page 63 (2001) J. Nagamatsu, N. Nakagawa, T. Muranaka, Y. Zenitani, and J. Akimitsu) and Sc³⁺B₂ with the same crystallographic AlB₂ structure is not superconductor above 0.3 degree's Kelvin.

### Technical problem to be solved

The research has been addressed recently to new superconducting diborides but it has been found that is very difficult to modify systematically MgB₂ through chemical substitution of magnesium in order to form new ternary superconducting compounds. Many trials have been done recently but only the Mn substitution for Mg up to a maximum of 5% in MgB₂ has been realized (J. Phys. Soc. Jpn. Vol. 70 Page 1889 (2001) S. Xu, Y. Moritomo, K. Kato, A. Nakimura) as described in the paper (Physica C, Vol 385 pag. 8-15 R.J. Cava, H. W. Zandbergen, K. Inumaru "The substitutional chemistry of MgB₂")

### Disclosure of Invention

The present invention as claimed to overcome said difficulties in the synthesis of new ternary superconducting intermetallics of chemical formula (M₁₋ₓRₓ)^{+y}B₂, where M and R are two different elements, made of superlattices of graphite-like superconducting boron layers intercalated by M/R layers that control the parameters that are needed for the material design of new high-temperature superconductors made by metal heterostructures at the atomic limit since they control the variation of the superconducting critical temperature: first, the charge density in the boron superconducting layers via the formal electron transfer of y electrons from M/R layers to boron layers; second, the spacing between the superconducting boron layers and therefore the period of the superlattice measured by the c axis of the AlB₂ structure; third, the microstrain of the graphite-like boron lattice due to the internal pressure induced by the lattice misfit between the boron and the intercalated M/R layers.

The Sc₁₋ₓMgₓB₂ compound can be used in industrial applications as a superconductor with variable T_{c} (x) for energy transport and electronic devices and detectors and it has a stability at high temperatures (being stable up to 1000 °C) superior to MgB₂ (being stable up to 850 °C).

In accordance with the present invention we provide a superconductor Sc₁ₓMgₓB₂ with high critical temperature as defined in claim 1.

The present invention is based on the discovery that the chemical synthesis of a ternary compound formed by scandium (Sc) and magnesium (Mg) intercalated between the boron layers with the AlB₂ structure and chemical formula (Sc₁₋ₓMgₓ)^{+y}B₂ with magnesium concentration x between 0.7 and 0.9 (0.7<x<0.9), showing that the Sc substitution for Mg in MgB₂ is realized in the range of scandium content between 10% and 30%.

In the (Sc₁₋ₓMgₓ)^{+y}B₂ compound the variation of superconducting critical temperature with x is well predicted by the process of "T_{c} amplification" by Fermi level tuning at a "shape resonance" in the superlattice of boron layers, that is realized by changing the formal charge transfer y=3-x from the Mg/Sc layers to the boron layers with minor variations of all lattice parameters of the crystalline structure; in this way the highest T_{c} is reached at the "shape resonance" for a interlayer charge transfer y in the range of 2.1<y<2.15.

### Brief Description of Drawings

- Fig. 1 shows the pictorial view of the Sc₁₋ₓMgₓB₂ intermetallic ternary compound made of layers of graphite-like boron (1) and layers of Sc/Mg (2) forming a superlattice of superconducting boron layers with period λₚ measured by the c axis of the AlB₂ crystallographic structure (C32, symmetry space group P6/mmm).
- Fig. 2 shows the x-ray powder diffraction pattern of several Sc₁₋ₓMgₓB₂ with x in the range 0.7<x<0.9.
- Fig. 3 shows the well resolved profile of the (110) X-ray diffraction line of the ternary compound Sc_{0.19}Mg_{0.81}B₂ (Sc₁₋ₓMgₓB₂ with x=0.81) compared with the similar diffraction line of the binary ScB₂ and MgB₂ diborides.
- Fig. 4 shows the variation of the lattice parameters a and c measured in picometers (pm) as a function of magnesium concentration x in Sc₁₋ₓMgₓB₂ with x in the range 0.7<x<0.9.
- Fig. 5 shows the variation of the superconducting critical temperature T_{c} measured in degree's Kelvin (K) (filled dots) as a function of magnesium concentration x in Sc₁₋ₓMgₓB₂ with x in the range 0.7<x<0.9 compared with the density of states DOS in the boron σ subband (solid line) calculated to predict the position of the shape resonance.

### Best Mode for Carrying out the Invention with

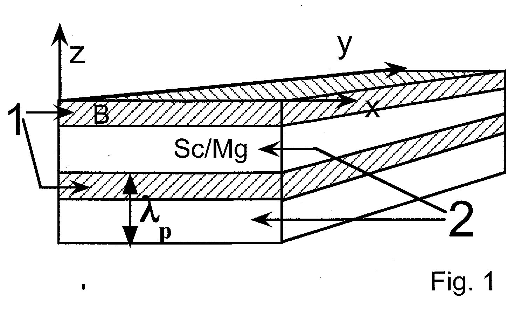

The present invention is based on the chemical synthesis of a ternary intermetallic compound formed by a heterostructure at atomic limit, as in Fig. 1, made of a superlattice of boron layers (1) intercalated with magnesium/scandium layers (2) of chemical formula Sc₁₋ₓMgₓB₂ with x in the range between 0.7 and 0.9,

The applicants have addressed their studies to show that it is possible to increase the critical temperature T_{C} by realizing the "shape resonance" condition in a "superlattice" of boron layers according with the cited patent SMHAL, tuning the charge density in the superconducting boron layers by chemical substitutions in the Sc/Mg layers in the ternary compound Sc₁₋ₓ MgₓB₂ where the lattice structure remains nearly unchanged by changing the chemical composition x.

The applicants have demonstrated that the Sc₁₋ₓMgₓB₂ compound, with x in the range 0.7<x<0.9, is formed by chemical synthesis characterized by the following main steps:
- preparation of pressed pellets of Mg/Sc/B elements with stoichiometric ratio Sc₁₋ₓMgₓB₂; the following example for the synthesis of the sample Sc_{0.19}Mg_{0.81}B₂ is useful to explain the invention:
   composition used in the pellet of 0.3 g:
   0.11079 g of magnesium
   0.06121 g of scandium
   0.128 g of boron.
- the pellets are closed in argon atmosphere in sealed tantalum vessels
- heat treatment in a furnace with argon atmosphere with the following procedure: first, heating the sample for 5 minutes at 1280 °C, second, heating the sample for one hour at 1150 °C, third heating the sample for 6 hours at 950 °C.

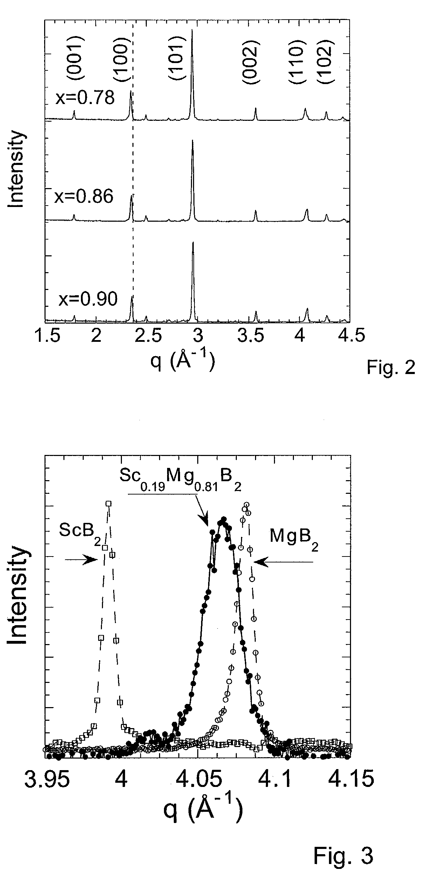

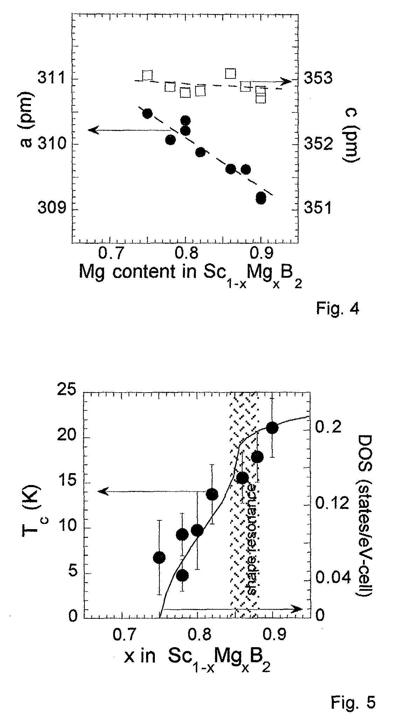

The powder x-ray diffraction data of the samples plotted in Fig. 2, show that the structure of Sc₁₋ₓMgₓB₂ is of the AlB₂ type AlB₂ crystallographic structure (C32, symmetry space group P6/mmm). The most common MgO impurity in the synthesis of diborides reported by other authors is not present in our samples since we use a procedure that avoid the interaction of Mg with oxygen. The known insolubility of MgB₂ with ScB₂ has been found for solid solutions at high Mg content, for x>0.9, and low Mg content, for x<0.5. Using the given procedure we have found a clear formation of the ternary intermetallic compounds Sc₁₋ₓMgₓB₂ with 0.7<x<0.9. For 0.7<x<0.8 we have found minority phases of abut 15% concentration of ScB₂ and/or of MgB₄. For 0.8<x<0.9 have found a minority phase of abut 15% concentration of MgB₂ and/or of MgB₄. The a-axis and the b-axis of the C32 crystallographic structure of Sc₁₋ₓMgₓB₂ as a function of x, extracted from the x-ray diffraction data, are plotted in Fig. 3. The measure of the c―axis provides the period (λₚ) of the superlattice of boron layers in the z direction (see Fig. 1). The c-axis remains nearly constant by changing x showing that the Mg and Sc ions have a similar ionic radius. The a-axis shows a systematic variation with x that allows to separate the (110) X-ray diffraction line of Sc₁₋ₓMgₓB₂from that of MgB₂ and that of ScB₂as it is reported in Fig. 4 for the case of Sc_{0.19}Mg_{0.81}B₂.

By knowing the crystallographic structure and the number of electrons transferred from the Sc/Mg layers to the boron layers y=3(1-x)+2x=3-x we can easily calculate the value of x-0.7 for tuning the Fermi level at the top of the σ subband of the boron superlattice using the available band calculations for MgB₂ (Phys. Rev. Lett. Vol. 86 Page 4366. (2001) J. M. An and W. E. Pickett) and a rigid band model. Therefore in the range x<0.7 the σ subband of the boron is full. In the range 0.7<x<0.87 the Fermi level is tuned between the top of the σ subband at x-0.7 and the "shape resonance" at x∼0.87. In this range of x the electron hopping between boron layers in the z direction is possible and the topology of the Fermi surface of the σ subband of the boron is three dimensional (3D). For x>∼0.87±0.03 the topology of the Fermi surface of the σ subband becomes 2D, like in MgB₂. Therefore for x∼0.87±0.03 the Fermi level is tuned to a "shape resonance" defined as the point where 1) the group velocity of the itinerant electronic σ holes in the z direction goes to zero; 2) the topology of the σ Fermi surface shows a 3D to 2D topology crossover; 3) the wave-vector k_{F} of the itinerant electronic charges in σ subband at the Fermi surface satisfies the "shape resonance" condition "G ―k _{F}∼ (π/λₚ)" where G is the reciprocal lattice vector in the xy plane and λₚ = c , where c is the c-axis of the C32 crystallographic structure. The applicants have investigated the superconducting properties of the Sc₁₋ₓ MgₓB₂ samples with different Mg content x in the range 0.7<x<0.9 by using a single coil inductance method measuring the complex ac impedance. The superconducting critical temperature T_{c} measured in degree's Kelvin (K) as a function of magnesium concentration x in Sc₁₋ₓMgₓB₂ is reported Fig. 5. T_{c} increases from about 4K to 22K going from x=0.7 to x=0.9. The amplification of the critical temperature from 4K to 22K is obtained by tuning the Fermi level, controlled by the charge transfer y=3-x, from the top of the σ subband at x=0.7±0.03 toward the "shape resonance" at x∼0.87±0.03 that is indicated in Fig. 5 by the inflection in the calculated curve of density of states (DOS) in the σ subband as a function of x.

## Claims

1. Superconductors of chemical formula Sc₁₋ₓMgₓB₂ with x tuned in the range between 0.7 and 0.9, being formed by a superlattice of first superconducting layers (1) made of boron (B) intercalated by second layers (2) made of magnesium and scandium (Sc/Mg) having a period λₚ in the direction (z) prepared by chemical synthesis at high temperature , where the amplification of the critical temperature T_{c} is obtained by changing the electronic charge transfer, y=3-x, from the (Sc/Mg) layers to the boron layers to tune the Fermi level in order to satisfy the "shape resonance" condition.

2. Ternary intermetallic Sc₁₋ₓMgₓB₂ compounds in accordance with the claim 1 where the superconducting critical temperature is controlled by changing the magnesium concentration x .

3. Method to realize superconducting ternary intermetallic compounds Sc₁₋ₓMgₓB₂ in accordance with the claim 1 by chemical synthesis **characterized by** the following steps (1) preparation of pressed pellets of Mg Sc B elements with stoichiometric ratio Sc₁₋ₓMgₓB₂ (2) closing the prepared pellets in argon atmosphere in sealed tantalum vessels (3) heating the sample, first, for 5 minutes at 1280 °C, second, for one hour at 1150 °C, third for 6 hours at 950°C.
